# EUROPÄISCHE PATENTSCHRIFT

(11) **EP 0 968 523 B1**
(45) Veröffentlichungstag und Bekanntmachung des Hinweises auf die Patenterteilung: **24.04.2002**
(21) Anmeldenummer: 98906918.2
(22) Anmeldetag: 05.02.1998
(51) Int. Cl.: H01L 21/288, H01L 21/60

(54) **VERFAHREN ZUM BILDEN EINER STRUKTURIERTEN METALLISIERUNG AUF EINEM HALBLEITERWAFER**
METHOD FOR FORMING A STRUCTURED METALLIZATION ON A SEMICONDUCTOR WAFER
PROCEDE PERMETTANT DE REALISER UNE METALLISATION STRUCTUREE SUR UNE PLAQUETTE A SEMI-CONDUCTEUR

(30) Priorität: 14.02.1997 DE 19705745
(43) Veröffentlichungstag der Anmeldung: 05.01.2000
(73) Patentinhaber: FRAUNHOFER-GESELLSCHAFT ZUR FÖRDERUNG DER ANGEWANDTEN FORSCHUNG E.V., 80636 München (DE); Pac Tech - Packaging Technologies GmbH, 14641 Nauen (DE)
(72) Erfinder: ASCHENBRENNER, Rolf, D-12203 Berlin (DE); AZDASHT, Ghassem, D-14052 Berlin (DE); ZAKEL, Elke, D-14612 Falkensee (DE); OSTMANN, Andreas, D-10585 Berlin (DE); MOTULLA, Gerald, D-13357 Berlin (DE)
(74) Vertreter: Schoppe, Fritz, Dipl.-Ing.
(86) Internationale Anmeldenummer: EP9800618
(87) Internationale Veröffentlichungsnummer: WO9836447

(56) Entgegenhaltungen:
- EP-A- 0 092 971
- EP-A- 0 382 298
- EP-A- 0 479 373
- EP-A- 0 535 864
- WO-A-95/02900
- US-A- 4 988 412
- US-A- 5 169 680
- ASCHENBRENNER R ET AL: "Electroless Nickel/Copper Plating as a New Bump Metallization" IEEE TRANSACTIONS ON COMPONENTS, PACKAGING AND MANUFACTURING TECHNOLOGY. PART B: ADVANCED PACKAGING., Bd. 18, Nr. 2, Mai 1995, NJ US, Seiten 334-338, XP002067164 in der Anmeldung erwähnt
- PATENT ABSTRACTS OF JAPAN vol. 017, no. 101 (E-1327), 2.März 1993 & JP 04 290249 A (NEC CORP), 14.Oktober 1992,
- PATENT ABSTRACTS OF JAPAN vol. 016, no. 539 (E-1289), 10.November 1992 & JP 04 206680 A (NORITAKE CO LTD), 28.Juli 1992, in der Anmeldung erwähnt
- PATENT ABSTRACTS OF JAPAN vol. 015, no. 423 (E-1127), 28.Oktober 1991 & JP 03 177048 A (TOSHIBA CORP), 1.August 1991,
- PATTERSON J C ET AL: "SELECTIVE ELECTROLESS COPPER METALLIZATION ON A TITANIUM NITRIDE BARRIER LAYER" MICROELECTRONIC ENGINEERING, Bd. 33, Nr. 1/04, Januar 1997, Seiten 65-73, XP000656758
- TING C H ET AL: "SELECTIVE ELECTROLESS METAL DEPOSITION FOR INTEGRATED CIRCUIT FABRICATION" JOURNAL OF THE ELECTROCHEMICAL SOCIETY, Bd. 136, Nr. 2, Februar 1989, MANCHESTER, NH, USA, Seiten 456-462, XP000024850 in der Anmeldung erwähnt

## Beschreibung

Die vorliegende Erfindung bezieht sich auf Verfahren zum Bilden einer strukturierten Metallisierung auf einem Halbleiterwafer und insbesondere Verfahren, die zur Erzeugung einer Umverdrahtung auf einer Chipoberfläche geeignet sind.

Die fortschreitende Miniaturisierung elektronischer Systeme erfordert eine zunehmende Verkleinerung der Chipgehäuse. Eine optimale Ausnutzung der Leiterplattenoberfläche kann nur durch die Verwendung einer Flip-Chip-Montage für ungehäuste Chips erreicht werden.

Die Padanordnung und das Rastermaß heute verfügbarer Chips sind durch die Möglichkeiten der Drahtbondtechnik begrenzt, da mittelfristig die überaus meisten Chips in gehäuster Form eingesetzt werden. Bei hochpoligen Chips wird daher ein sehr geringes Rastermaß und ferner sehr kleine Padflächen eingesetzt. Üblich sind Padgrößen von 80 x 80 µm und ein Rastermaß von 100 µm. Bei derartig kleinen Konfigurationen kann zwar eine Kontaktierung durch Bonddrähte, nicht jedoch durch die klassische Flip-Chip-Technik realisiert werden.

Bei dem oben genannten feinen Rastermaß existiert hinsichtlich der klassischen Flip-Chip-Technik eine Vielzahl von Problemen. Diese beziehen sich auf Lotbrücken zwischen benachbarten Lotbumps, auf Lötstoplacköffnungen auf der Leiterplatte sowie die Ausrüstung für die ultrafeinen Abstände (Pitch).

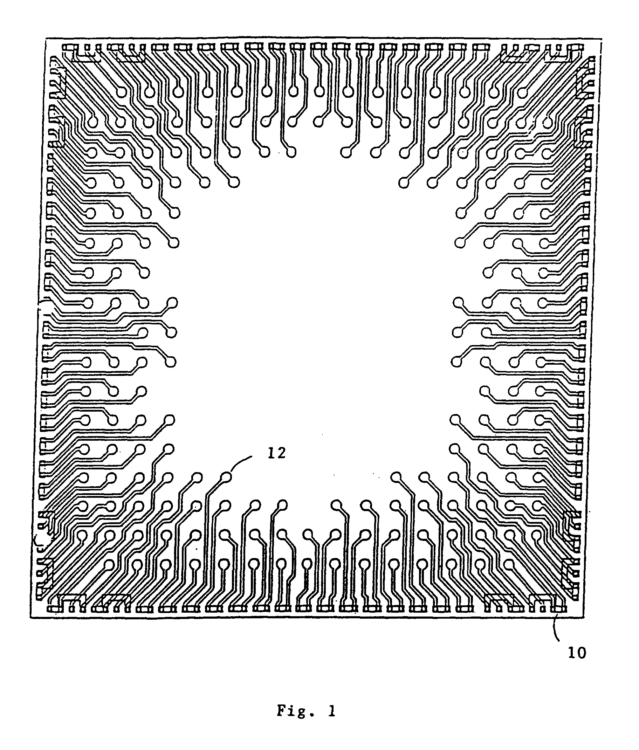

Um die oben beschriebene Problematik zu vermeiden, sind in der Technik Chipgehäuse bekannt, bei denen die Anschlüsse des Chips auf eine flächige Anordnung umgelegt werden. Ein Beispiel einer derartigen flächigen Anordnung ist in Fig. 1 dargestellt, bei dem eine Vielzahl von Randpads, Bezugszeichen 10, in eine entsprechende Vielzahl von flächig angeordneten Pads, Bezugszeichen 12, umverdrahtet sind. Ein weiteres Beispiel einer Umverdrahtung ist beispielsweise die Umverdrahtung von zwei Pads auf einem Chip in sehr große Bumps, die auf einer Chipoberfläche angeordnet sind, wobei derartige sehr große Bumps in der Technik als Megabumps bezeichnet werden.

Um eine Umverdrahtungstechnik auf der Chipoberfläche zur Veränderung der Bumpgeometrie und der Anschlüsse, sowie eine Verteilung der Anschlüsse von der Kante des Chips in eine Flächenverteilung zu realisieren, gibt es verschiedene Möglichkeiten. Gemäß dem Stand der Technik werden Metallisierungslagen galvanisch abgeschieden, wobei dieselben nachfolgend durch Photolithographie strukturiert werden, woraufhin eine Ätzung der nicht benötigten Metallisierungsflächen erfolgt. Die ganzflächige Abscheidung von Metall kann neben der galvanischen Abscheidung auch durch Bedampfung erfolgen.

Gemäß dem herkömmlichen Verfahren zur Umverdrahtung ergibt sich folgender Prozeßfluß. Zunächst wird ein photostrukturierbares Dielektrikum auf eine Hauptoberfläche eines Halbleiterwafers, die mit einer Passivierungsschicht zur Festlegung von Bondpads versehen ist, aufgebracht. Nachfolgend werden die Bondpads in dem Dielektrikum geöffnet. Im Anschluß daran erfolgt ein Sputterverfahren zur Erzeugung einer ganzflächigen Metallisierung auf dem Wafer, d.h. auf den Bondpads und auf dem Dielektrikum. Die ganzflächig aufgebrachte Metallisierung wird nachfolgend unter Verwendung einer Photolackmaske strukturiert, wodurch die Umverdrahtungsmetallisierung festgelegt wird. Auf der nun festgelegten dünnen Metallisierung wird im Anschluß eine galvanische Metallabscheidung durchgeführt. Im Anschluß daran wird die verbleibende Photolackmaske entfernt und die Basismetallisierung selektiv geätzt. Abschließend wird eine Lötstopmaske, die die flächigen Pads festlegt, auf die Oberfläche des Wafers aufgebracht.

Vor allem die Kosten für die Sputter-Ausrüstung, die in der Regel sehr hoch sind, stellen einen Nachteil des bekannten Verfahrens dar. Ferner muß nach dem Erzeugen der ganzflächigen Metallisierung auf dem Wafer ein weiteres photolithographisches Verfahren unter Verwendung einer Photolackmaske durchgeführt werden. Das bekannte Verfahren ist somit relativ aufwendig.

Die EP-A-0151413 bezieht sich auf Verfahren zur selektiven stromlosen Metallabscheidung auf dielektrischen Oberflächen. Dabei wird eine dielektrische Oberfläche behandelt, indem selektiv vorgewählte Bereiche derselben mittels einer Vorbehandlungslösung, beispielsweise einer Palladium-Chlorid-Lösung aktiviert werden, um nachfolgend eine stromlose Metallabscheidung auf den aktivierten Bereichen durchzuführen.

Aus J. Electrochem. Soc. 1989, Vol. 136, Nr. 2, S. 456-462, sind Verfahren zur selektiven stromlosen Metallabscheidung zur Verwendung bei der Herstellung von integrierten Schaltungen, und insbesondere zur Herstellung von Mehrebenen-Zwischenverbindungen in VLSI-Schaltungen bekannt. Dabei werden Leitermuster gebildet, indem zunächst eine dünne Aluminiumschicht über einer SiO₂-Oberfläche abgeschieden wird, um eine Haftschicht zwischen der späteren Metallisierung und der SiO₂-Schicht zu bilden. Nachfolgend wird beispielsweise durch eine geeignete Maske selektiv eine stromlose Metallabscheidung durchgeführt, um die gewünschten Leitermuster zu erzeugen.

In IEEE Transactions on Components, Packaging, and Manufacturing Technology, Part B, 1995, Vol. 18, Nr. 2, S. 334-338 sind Verfahren zur stromlosen Nickel/Kupfer-Abscheidung auf Bondpads eines mit einer Passivierungsschicht versehenen Siliziumwafers beschrieben, um Metallbumps zu erzeugen.

Die JP-A-4-206680 offenbart das Bilden einer Schicht aus einem aktivierten dielektrischen Material 2 auf einem Substrat 1, um auf Seitenflächen des aktivierten dielektrischen Materials stromlos Metallschichten 4 abzuscheiden. Um eine Abscheidung auf der zum Substrat 1 parallelen Oberfläche des aktivierten dielektrischen Materials zu verhindern, ist auf diese Oberfläche eine Schicht aus einem inaktiven dielektrischen Material 3 aufgebracht.

Ausgehend von dem oben genannten Stand der Technik liegt der vorliegenden Erfindung die Aufgabe zugrunde, Verfahren zum Bilden einer strukturierten Metallisierung auf einem Halbleiterwafer, insbesondere um eine Umverdrahtung von Kantenanschlüssen des Wafers in eine flächige Konfiguration zu ermöglichen, zu schaffen, die einfacher, schneller und kostengünstiger als bekannte Verfahren sind.

Diese Aufgabe wird durch Verfahren gemäß den Ansprüchen 1 und 2 gelöst.

Die vorliegende Erfindung basiert auf der Idee, ein Abscheide- und Strukturierungs- Verfahren zu schaffen, das auf der selektiven chemischen Abscheidung von Metall auf einer geeignet bekeimten Unterlage beruht, bzw. der strukturierten Aufbringung eines leitfähigen Materials. Zu diesem Zweck wird auf den Wafern ein aktiviertes Dielektrikum für eine additive chemische Abscheidung oder ein leitfähiges Material aufgebracht.

Die genannten Materialien, d.h. das aktivierte Dielektrikum oder ein leitfähiges Material, können beispielsweise durch einen Schablonenauftrag durch eine Schablone, ein Dispensieren, eine ganzflächige Auftragung und eine anschließende photolithographische Strukturierung derselben, sowie eine ganzflächige Auftragung und eine Aktivierung der zu metallisierenden Bereiche durch eine Belichtung realisiert werden.

Die vorliegende Erfindung bezieht sich auf Verfahren zum Bilden einer strukturierten Metallisierung auf der Oberfläche eines Halbleiterwafers, auf der bereits eine Passivierungsschicht aufgebracht ist, die strukturiert ist, um zumindest ein Bondpad festzulegen. Derartige Bondpads sind üblicherweise als Aluminium-Bondpads realisiert.

Gemäß einem ersten Aspekt der vorliegenden Erfindung wird zunächst ein Metallbump auf dem zumindest einen Bondpad, beispielsweise durch eine chemische Metallabscheidung oder durch photolithographische Verfahren, erzeugt. Nachfolgend wird ein aktiviertes Dielektrikum auf den Bereichen der Passivierungsschicht, auf denen die strukturierte Metallisierung gebildet werden soll, erzeugt, woraufhin Metall auf dem aktiviertem Dielektrikum und dem Metallbump chemisch abgeschieden wird.

Gemäß einem weiteren Aspekt der vorliegenden Erfindung wird das zumindest eine Bondpad zunächst für eine chemische Metallabscheidung vorbereitet, d.h. aktiviert. Ein aktiviertes Dielektrikum wird auf den Bereichen der Passivierungsschicht, auf denen die strukturierte Metallisierung gebildet werden soll, erzeugt. Nachfolgend wird Metall chemisch auf den aktivierten Bereichen und dem aktivierten Bondpad abgeschieden.

Bei Verwendung der erfindungsgemäßen Verfahren zur Umverdrahtung von Kanten-Pads auf einem Chip in eine flächige Konfiguration der Pads wird nach der chemischen Metallabscheidung jeweils ein Lötstoplack auf die Oberfläche des Wafers, auf der die strukturierte Metallisierung gebildet ist, aufgebracht, woraufhin Öffnungen für die flächige Padanordnung in dem Lötstoplack erzeugt werden.

Die vorliegende Erfindung schafft somit Verfahren zum Bilden einer strukturierten Metallisierung auf einem Halbleiterwafer, insbesondere zur Umverdrahtung, die ohne eine kostenspielige Sputter-Vorrichtung auskommen. Ferner können die erfindungsgemäßen Verfahren im Vergleich zu bekannten Verfahren einfacher und schneller durchgeführt werden, was weitere Kosteneinsparungen mit sich bringt.

Bevorzugte Ausführungsbeispiele der vorliegenden Erfindung werden nachfolgend bezugnehmend auf die beiliegenden Zeichnungen näher erläutert. Es zeigen:
- Fig. 1: eine Draufsicht einer beispielhaften Umverdrahtung von Kanten-Pads in eine flächige Padkonfiguration;
- Fig. 2a) bis d): schematische Querschnittansichten zur Erläuterung des Verfahrens gemäß dem ersten Aspekt der vorliegenden Erfindung; und
- Fig. 3a) bis c): schematische Querschnittansichten zur Erläuterung des Verfahrens gemäß dem zweiten Aspekt der vorliegenden Erfindung.

An dieser Stelle sei darauf hingewiesen, daß in sämtlichen Figuren für jeweils gleiche Elemente gleiche Bezugszeichen verwendet sind.

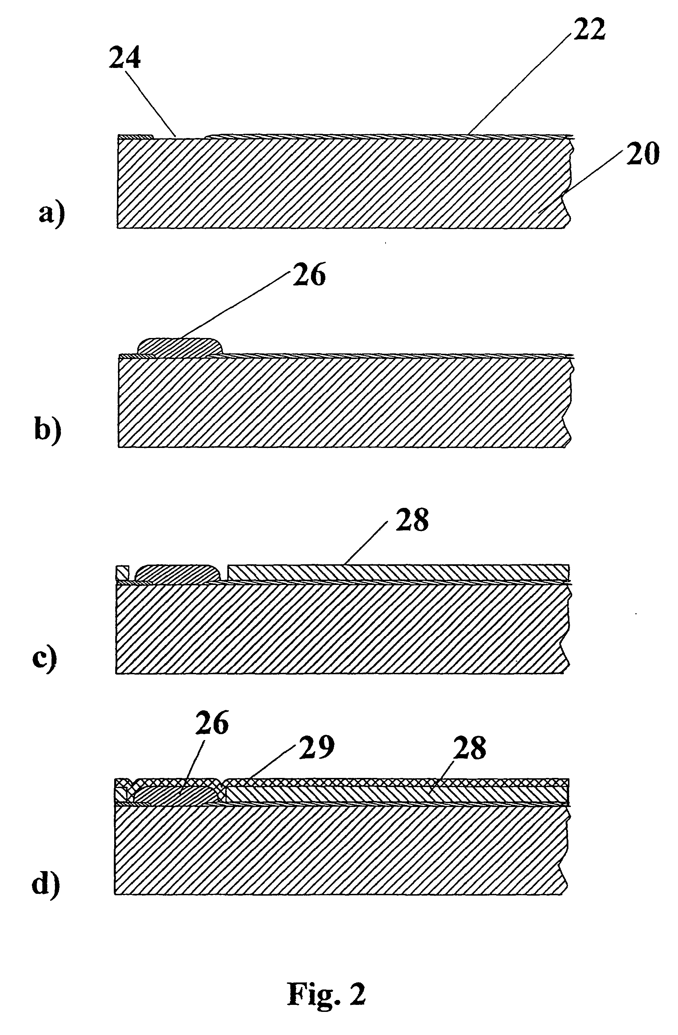

In den Fig. 2a) und 3a), ist jeweils eine schematische Teilquerschnittansicht eines Halbleiterwafers dargestellt, der den Ausgangspunkt der erfindungsgemäßen Verfahren darstellt. Ein Halbleiterwafer (20) ist auf einer Hauptoberfläche desselben mit einer Passivierungsschicht (22) versehen. In der Passivierungsschicht (22) sind Bondpads (24) angeordnet. Diese Bondpads (24) sind üblicherweise als Aluminium-Bondpads ausgebildet. Der Halbleiterwafer (20) besteht vorzugsweise aus Silizium, wobei die Passivierungsschicht (22) aus Siliziumnitrid besteht. Eine derartige Halbleiterstruktur ist in dieser Form von Halbleiterherstellern erhältlich.

Bezugnehmend auf Fig. 2 wird nachfolgend ein bevorzugtes Ausführungsbeispiel des Verfahrens gemäß dem ersten Aspekt der vorliegenden Erfindung näher erläutert. Ausgehend von dem in Fig. 2a) dargestellten Ausgangssubstrat wird zunächst eine chemische, d.h. stromlose Metallabscheidung auf dem Aluminium-Bondpad (24) durchgeführt. Durch diese Abscheidung wird ein Metallbump (26) auf dem Bondpad (24) erzeugt, wie in Fig. 2b) zu sehen ist. Es ist offensichtlich, daß entsprechend einer beliebigen Anzahl von Bondpads auf dem Halbleiterwafer bei diesem Schritt eine Vielzahl von Metallbumps erzeugt werden können. Um die chemische Metallabscheidung zu realisieren, müssen die Aluminium-Bondpads zunächst einer Aktivierung, beispielsweise einer Palladium-Aktivierung, unterworfen werden.

Neben der chemischen Metallabscheidung können die Metallbumps auch durch photolithographische Verfahren unter Verwendung eines Photolacks erzeugt werden.

Gemäß dem vorliegenden Ausführungsbeispiel wird nun ein Dielektrikum auf die Passivierung (22) des Wafers (20) aufgebracht, wobei dieses Aufbringen mittels eines Schablonendrucks oder alternativ ganzflächig mit anschließender photolithographischer Strukturierung erfolgen kann. Bei der ganzflächigen Auftragung des Dielektrikums wird in bekannter Weise eine Photomaske aufgebracht, das Bondpad und die Strukturen, die später keine Leiterbahnen darstellen sollen, belichtet, und nachfolgend die belichteten Bereiche entfernt.

In Fig. 2c) ist die Struktur nach der Strukturierung des Dielektrikums (28) dargestellt. Zwischen dem Metallbump (26) und dem Dielektrikum (28) darf nur ein kleiner Abstand existieren. Alternativ können sich der Metallbump und das Dielektrikum (28) leicht berühren. Das Dielektrikum (28) kann bei der Aufbringung desselben bereits für eine nachfolgende chemische Metallisierung aktiviert sein, beispielsweise durch Palladiumpartikel. Alternativ kann das Dielektrikum nach dem Aufbringen desselben in einem naßchemischen Verfahren bekeimt werden, beispielsweise durch Eintauchen in eine Palladium-Chlorid-Lösung.

Wie in Fig. 2c) dargestellt ist, weist das Dielektrikum (28) die gleiche Höhe wie der Metallbump (26) auf. Dies kann durch das Einstellen der Auftragsdicke des Dielektrikums abhängig von dem verwendeten Prozeßablauf realisiert werden. Es ist jedoch auch möglich, daß das Dielektrikum (28) nach dem Auftragen desselben eine größere Höhe als der Metallbump (26) aufweist, was eine Zurückätzung des Dielektrikums nach dem Aufbringen desselben auf die Höhe des Metallbumps erforderlich macht.

In einem nachfolgenden Schritt wird auf dem aktivierten Dielektrikum eine chemische Metallabscheidung durchgeführt. Bei dieser chemischen Metallabscheidung wird stromlos Gold, Nickel, Kupfer oder Palladium auf dem aktivierten Dielektrikum und dem Metallbump abgeschieden, um eine Metallisierungsschicht (29) zu bilden. Das chemisch abgeschiedene Metall wächst mit dem Metallbump zusammen und bildet damit eine elektrisch leitfähige Verbindung von dem Metallbump zu der auf dem Dielektrikum (28) angeordneten Metallisierungsschicht, wodurch die elektrische Verbindung von dem Bondpad zu der Umverdrahtung realisiert wird. Bei dem bevorzugten Ausführungsbeispiel wird im Anschluß ein Lötstoplack mit Öffnungen für die flächige Padanordnung, deren Pads durch das erfindungsgemäße Verfahren beispielsweise mit Kanten-Pads verbunden werden, aufgebracht.

Alternativ kann das aktivierte Dielektrikum auf den Bereichen der Passivierungsschicht, auf denen die strukturierte Metallisierung gebildet werden soll, erzeugt werden, indem das Dielektrikum ganzflächig mit Ausnahme der Metallbumps aufgebracht wird und die zu metallisierenden Bereiche durch Belichtung aktiviert werden.

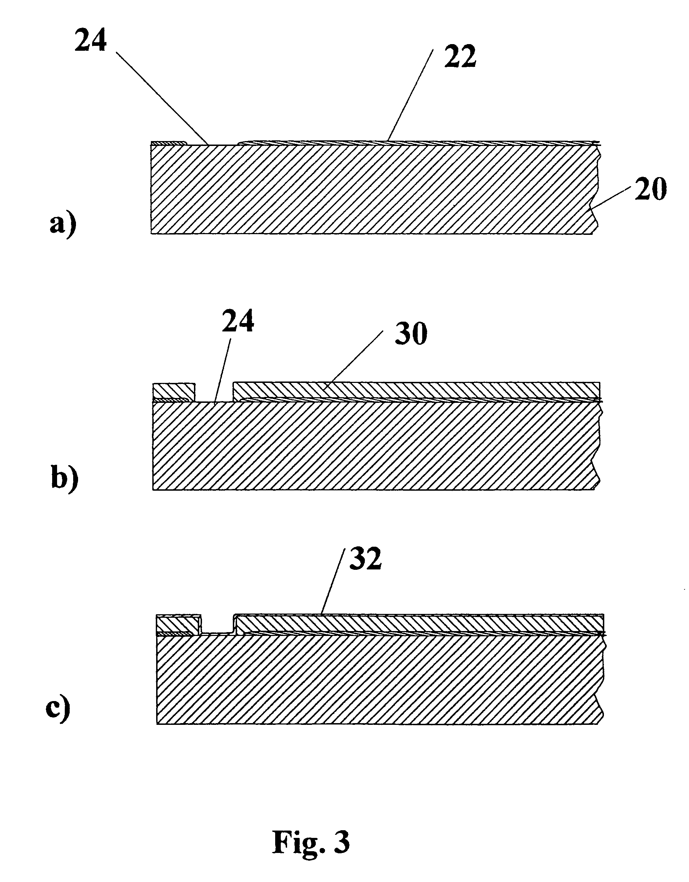

Bezugnehmend auf Fig. 3 wird nachfolgend ein bevorzugtes Ausführungsbeispiel des Verfahrens gemäß dem zweiten Aspekt der vorliegenden Erfindung erläutert. In Fig. 3a) ist wiederum der Ausgangswafer (20) mit der Passivierungsschicht (22) und dem Bondpad (24) dargestellt. Auf die Oberfläche des Wafers (20), auf dem die Passivierungsschicht (22) angeordnet ist, wird ganzflächig ein Dielektrikum (30) aufgebracht. Das Dielektrikum (30) wird beispielsweise mittels eines Photolithographieverfahrens strukturiert, um zum einen das Bondpad (24) freizulegen und zum anderen die Struktur der nachfolgend aufzubringenden Metallisierung festzulegen. Die sich ergebende Struktur ist in Fig. 3b) dargestellt. Nachfolgend wird das Dielektrikum (30) und das Bondpad (24) vorzugsweise durch ein naßchemisches Verfahren bekeimt, d.h. durch das Eintauchen des Wafers in eine Palladium-Chorid-Lösung. Auf die nunmehr vorliegende Struktur wird mittels einer chemischen Metallabscheidung eine Metallisierungsschicht (32) aufgebracht. Die Metallisierungsschicht wird durch die chemische Metallabscheidung auf dem aktivierten Dielektrikum (30) und den aktivierten Bondpads (24) abgeschieden, wie in Fig. 3c) dargestellt ist. Durch das bezugnehmend auf Fig. 3 beschriebene Verfahren kann das Ankontaktieren der auf dem Dielektrikum abgeschiedenen Metallschicht an das Bondpad (24) in einem Schritt ohne einen Metallbump erfolgen.

Die Verfahren gemäß der vorliegenden Erfindung sind vorteilhaft bei der Erzeugung einer Umverdrahtung auf einem Chip geeignet. Durch die vorliegende Erfindung kann eine derartige Umverdrahtung unter Einsparung von Prozeßschritten verglichen mit bekannten Verfahren kostengünstiger und schneller realisiert werden.

## Patentansprüche

1. Verfahren zum Bilden einer strukturierten Metallisierung (30) auf einem Halbleiterwafer (20), wobei auf eine Hauptoberfläche des Wafers (20) eine Passivierungsschicht (22) aufgebracht ist, die strukturiert ist, um zumindest ein Bondpad (24) festzulegen, mit folgenden Schritten:
a1) Erzeugen eines Metallbumps (26) auf dem zumindest einen Bondpad (24);
b1) selektives Erzeugen eines aktivierten Dielektrikums (28) auf den Bereichen der Passivierungsschicht (22), auf denen die strukturierte Metallisierung (30) gebildet werden soll; und
c1) chemisches, d.h. stromloses Abscheiden von Metall direkt auf dem aktivierten Dielektrikum (28) und dem Metallbump (26) in einem gemeinsamen Abscheidungsschritt, derart, daß die auf dem aktivierten Dielektrikum gebildete strukturierte Metallisierung und das auf dem Metallbump chemisch abgeschiedene Metall elektrisch leitfähig verbunden sind.

2. Verfahren zum Bilden einer strukturierten Metallisierung (32) auf einem Halbleiterwafer (20), wobei auf eine Hauptoberfläche des Wafers (20) eine Passivierungsschicht (22) aufgebracht ist, die strukturiert ist, um zumindest ein Bondpad (24) festzulegen, mit folgenden Schritten:
a2) selektives Erzeugen eines aktivierten Dielektrikums (30) auf den Bereichen der Passivierungsschicht (22), auf denen die strukturierte Metallisierung (32) gebildet werden soll, und Aktivieren des zumindest einen Bondpads (24);
b2) Chemisches, d.h. stromloses Abscheiden von Metall direkt auf den aktivierten Bereichen und dem aktivierten Bondpad (24) in einem gemeinsamen Abscheidungsschritt, derart, daß die auf dem aktivierten Dielektrikum gebildete strukturierte Metallisierung und das auf dem Bondpad chemisch abgeschiedene Metall elektrisch leitfähig verbunden sind.

3. Verfahren gemäß Anspruch 1, wobei in dem Schritt a1) der Metallbump (26) durch chemische, d.h. stromlose Metallabscheidung auf dem zumindest einen Bondpad (24) gebildet wird.

4. Verfahren gemäß Anspruch 1, wobei in dem Schritt a1) der Metallbump (26) mittels Photolithographischer Verfahren auf dem zumindest einen Bondpad (24) gebildet wird.

5. Verfahren gemäß Anspruch 1 oder Anspruch 2, wobei in den Schritten b1) und a2) das Dielektrikum (28; 30) zunächst ganzflächig aufgebracht und nachfolgend mittels photolithographischer Verfahren strukturiert wird.

6. Verfahren gemäß Anspruch 5, bei dem das aufgebrachte Dielektrikum (28; 30) Palladiumpartikel enthält.

7. Verfahren gemäß Anspruch 5, bei dem das Dielektrikum (28; 30) nach dem Strukturieren durch Eintauchen in eine Palladium-Chloridlösung aktiviert wird.

8. Verfahren gemäß Anspruch 7 in Rückbezug auf Anspruch 2, bei dem durch das Eintauchen in die Palladium-Chloridlösung ferner das zumindest eine Bondpad (24) aktiviert wird.

9. Verfahren gemäß einem der Ansprüche 1 bis 8, bei dem bei der chemischen, d.h. stromlosen Metallabscheidung jeweils Gold, Nickel, Kupfer oder Palladium abgeschieden wird.

10. Verfahren gemäß einem der Ansprüche 1 bis 9 zur Umverdrahtung von Padflächen auf einem Wafer in eine flächige Anordnung, bei dem jeweils nach der chemischen, d.h. stromlosen Metallabscheidung ein Lötstoplack auf die Oberfläche des Wafers, auf der die strukturierte Metallisierung gebildet ist, aufgebracht wird, woraufhin Öffnungen für die flächige Padanordnung in dem Lötstoplack erzeugt werden.

## Claims

1. Method for forming a structured metallization (30) on a semiconductor wafer (20), wherein a passivation layer (22) is deposited on a main surface of the wafer (20), which layer is structured so as to specify at least one bond pad (24), the method comprising the following steps:
a1) generating a metal bump (26) on the at least one bond pad (24);
b1) selectively generating an activated dielectric (28) on those areas of the passivation layer (22) on which the structured metallization (30) is to be formed; and
c1) chemical, i.e. electroless, depositing of metal directly on the activated dielectric (28) and the metal bump (26) in a common deposition step, such that the structured metallization formed on the activated dielectric, and the metal chemically deposited on the metal bump are connected in an electrically conductive manner.

2. Method for forming a structured metallization (32) on a semiconductor wafer (20), wherein a passivation layer (22) is deposited on a main surface of the wafer (20), which layer is structured so as to specify at least one bond pad (24), the method comprising the following steps:
a2) selectively generating an activated dielectric (30) on those areas of the passivation layer (22) on which the structured metallization (32) is to be formed, and activating the at least one bond pad (24);
b2) chemical, i.e. electroless, depositing of metal directly on the activated areas and the activated bond pad (24) in a common deposition step, such that the structured metallization formed on the activated dielectric, and the metal chemically deposited on the bond pad are connected in an electrically conductive manner.

3. Method as claimed in claim 1, wherein in step al), the metal bump (26) is formed by a chemical, i.e. electroless, metal deposition on the at least one bond pad (24).

4. Method as claimed in claim 1, wherein in step a1), the metal bump (26) is formed on the at least one bond pad (24) by means of photolithographic methods.

5. Method as claimed in claim 1 or 2, wherein in steps b1) and a2) the dielectric (28; 30) is initially applied on the entire surface and is subsequently structured by means of photolithographic methods.

6. Method as claimed in claim 5, wherein the dielectric (28; 30) applied contains palladium particles.

7. Method as claimed in claim 5, wherein the dielectric (28; 30) is activated, after the structuring, by being immersed in a palladium chloride solution.

8. Method as claimed in claim 7 with reference to claim 2, wherein the at least one bond pad (24) is also activated by being immersed in the palladium chloride solution.

9. Method as claimed in any of claims 1 to 8, wherein gold, nickel, copper or palladium, respectively, is deposited in the chemical, i.e. electroless, metal deposition.

10. Method as claimed in any of claims 1 to 9 for rewiring pad surfaces on a wafer into a spread-out arrangement, wherein a solder barrier varnish is applied, after the chemical, i.e. electroless, metal deposition, onto the surface of the wafer on which the structured metallization is formed, whereupon openings for the spread-out pad arrangement in the solder barrier varnish are created.

## Revendications

1. Procédé pour réaliser une métallisation structurée (30) sur une plaquette à semi-conducteur (20), sur une surface principale de la plaquette (20) étant appliquée une couche de passivation (22) qui est structurée, afin d'établir au moins un plot de connexion (24), aux étapes suivantes consistant à :
a1) générer une bosse de métal (26) sur l'au moins un plot de connexion (24);
b1) générer sélectivement un diélectrique activé (28) sur les zones de la couche de passivation (22) sur lesquelles doit être formée la métallisation structurée (30) ; et
c1) déposer chimiquement, c'est-à-dire sans courant, du métal directement sur le diélectrique activé (28) et sur la bosse de métal (26), en une étape de dépôt commune, de sorte que la métallisation structurée formée sur le diélectrique activé et le métal déposé chimiquement sur la bosse de métal sont reliées de manière électroconductrice.

2. Procédé pour réaliser une métallisation structurée (30) sur une plaquette à semi-conducteur (20), sur une surface principale de la plaquette (20) étant appliquée une couche de passivation (22) qui est structurée, afin d'établir au moins un plot de connexion (24), aux étapes suivantes consistant à :
a2) générer sélectivement un diélectrique activé (30) sur les zones de la couche de passivation (22) sur lesquelles doit être formée la métallisation structurée (32) et activer l'au moins un plot de connexion (24) ;
b2) déposer chimiquement, c'est-à-dire sans courant, du métal directement sur les zones activées et sur le plot de connexion (24) activé, en une étape de dépôt commune, de sorte que la métallisation structurée formée sur le diélectrique activé et le métal déposé chimiquement sur le plot de connexion sont reliées de manière électroconductrice.

3. Procédé selon la revendication 1, dans lequel, à l'étape a1), la bosse de métal (26) est formée par dépôt chimique de métal, c'est-à-dire sans courant, sur l'au moins un plot de connexion (24).

4. Procédé selon la revendication 1, dans lequel, à l'étape a1), la bosse de métal (26) est formée sur l'au moins un plot de connexion (24) à l'aide de procédés photolithographiques.

5. Procédé selon la revendication 1 ou la revendication 2, dans lequel, aux étapes b1) et a2), le diélectrique (28 ; 30) est tout d'abord appliqué sur toute la surface et ensuite structuré à l'aide de procédés photolithographiques.

6. Procédé selon la revendication 5, dans lequel le diélectrique appliqué (28 ; 30) contient des particules de palladium.

7. Procédé selon la revendication 5, dans lequel le diélectrique (28 ; 30) est activé, après la structuration, par immersion dans une solution de chlorure de palladium.

8. Procédé selon la revendication 7 avec renvoi à la revendication 2, dans lequel par l'immersion dans la solution de chlorure de palladium est, par ailleurs, activé l'au moins un plot de connexion (24).

9. Procédé selon l'une des revendications 1 à 8, dans lequel, lors du dépôt chimique de métal, c'est-à-dire sans courant, il est chaque fois déposé de l'or, du nickel, du cuivre ou du palladium.

10. Procédé selon l'une des revendications 1 à 9 pour le recablage de surfaces de plot sur une plaquette selon une disposition à plat, dans lequel, après le dépôt chimique de métal, c'est-à-dire sans courant, il est chaque fois appliqué une laque d'arrêt de brasure sur la surface de la plaquette sur laquelle est formée la métallisation structurée, après quoi il est généré dans la laque d'arrêt de brasure des ouvertures pour la disposition à plat de plots.
